# FASCICULE DE BREVET EUROPEEN

(11) **EP 2 884 353 B1**
(45) Date de publication et mention de la délivrance du brevet: **31.01.2018**
(21) Numéro de dépôt: 14186525.3
(22) Date de dépôt: 26.09.2014
(51) Int. Cl.: G04G 17/06, G04G 21/08, H05K 1/18, H05K 5/00

(54) **Objet électronique portable tactile**
Tragbares elektronisches berührungsempfindliches Objekt
Touch-sensitive portable electronic object

(30) Priorité: 18.10.2013 EP 13189341
(43) Date de publication de la demande: 17.06.2015
(73) Titulaire: ETA SA Manufacture Horlogère Suisse, 2540 Grenchen (CH)
(72) Inventeur: Jufer, Martin, 4917 Melchnau (CH); Schwegler, Stephan, 8055 Zurich (CH); Helfenstein, Sylvain, 2543 Lengnau (CH)
(74) Mandataire: Goulette, Ludivine

(56) Documents cités:
- EP-A1- 2 273 348
- US-A- 4 064 688
- US-A- 4 255 802
- US-A1- 2002 118 605
- US-A1- 2012 099 406

## Description

L'invention concerne un objet portable électronique muni d'un boîtier comprenant une carrure fermée par un fond et par une glace et une lunette fixée à la carrure, ledit boîtier enfermant au moins un module électronique constitué d'un circuit imprimé sur lequel est fixé au moins un circuit de contrôle envoyant des informations à des moyens d'affichage, ledit objet comportant en outre des moyens de commande tactiles comprenant au moins un substrat sur lequel au moins une électrode est déposée, ladite électrode étant électriquement reliée au circuit de contrôle par une piste conductrice.

### ARRIERE PLAN TECHNOLOGIQUE

Un objet portable électronique comme un appareil électronique ou par exemple une pièce d'horlogerie portable comprend une boîte généralement composée d'une carrure fermée par un fond et par une glace. Dans cette boîte, un mouvement horloger est agencé, ce dernier pouvant être électro-mécanique ou totalement électronique. Ce mouvement horloger est agencé pour fournir une information horaire, ladite information horaire étant affichée via des moyens d'affichage analogiques ou numériques. La pièce d'horlogerie comprend en outre des moyens de commande permettant à l'utilisateur d'interagir avec ladite pièce d'horlogerie.

En général, les moyens de commande se présentent sous la forme de boutons poussoirs ou d'une couronne agissant mécaniquement sur ledit mouvement horloger. Or, ces poussoirs et couronnes peuvent être complétés avec une interface tactile. Cette interface tactile est utilisée pour améliorer l'interactivité de la pièce d'horlogerie et pour simplifier les manipulations surtout lorsque la pièce d'horlogerie propose un nombre conséquent de menus et de fonctions.

Cette interface tactile peut être une interface tactile résistive ou une interface tactile capacitive. Pour le cas d'une interface tactile capacitive, celle-ci peut se présenter sous la forme d'une électrode placée sur la face inférieure de la glace, cette glace représentant un élément électriquement non conducteur. Cette électrode est soumise à un champ électrique. Lorsque l'utilisateur veut activer l'interface, il exerce un contact sur la face extérieure de la glace, de préférence avec son doigt. On entend par là que ce contact peut être un appui ou un effleurement. Ce contact entraîne l'apparition d'une capacité additionnelle qui se forme entre ladite électrode et le doigt qui est un élément électriquement conducteur. Cette variation de capacité est détectée par le mouvement horloger électronique qui va agir selon sa programmation. Cette interface tactile est réalisée sur la glace de la montre et non pas sur le boîtier car celui-ci est généralement réalisé en métal et est donc électriquement conducteur. Il ne permet pas l'apparition d'une capacité.

Néanmoins, ces interfaces tactiles agencées sur la glace de la pièce d'horlogerie présentent l'inconvénient de ne pas permettre pas une visibilité optimale des informations. En effet, le fait d'avoir une interface tactile agencée sur la glace de la pièce d'horlogerie implique que l'utilisateur doit régulièrement mettre ses doigts sur la glace. Cela a pour conséquences que la visibilité des informations affichées sur le cadran est régulièrement réduite par les doigts de l'utilisateur. Ce dernier a donc plus de difficultés à prendre connaissances des informations fournies par la pièce d'horlogerie.

Par ailleurs, ces touches tactiles sont généralement réalisées en déposant une couche métallique telle une couche ITO pour Indium-Tin-Oxide sur un substrat comme la glace. Or, un inconvénient de l'application d'une telle couche ITO sur la glace est qu'il s'agit d'une opération complexe et coûteuse. Par conséquent, une extrême rigueur de fabrication est nécessaire pour avoir un bon rendement de production.

Le document EP 2 273 348 décrit un objet électronique portable selon le préambule de la revendication indépendante 1 annexée.

### RESUME DE L'INVENTION

L'invention a pour but de pallier les inconvénients de l'art antérieur en proposant de fournir un objet électronique portable tactile qui soit plus simple à produire et moins coûteux et plus souple d'utilisation.

A cet effet, l'invention concerne un objet électronique portable tel que défini par la revendication indépendante 1. Dans un premier mode de réalisation avantageux, le support est réalisé en un plastique tel que le polyimide, l'électrode étant une couche de matériaux conducteurs déposée sur ledit support.

Dans un second mode de réalisation avantageux, les moyens de commande tactiles comprennent une pluralité de supports sur chacun desquels une électrode est agencée.

Dans un troisième mode de réalisation avantageux, les moyens de commande tactiles comprennent une pluralité de supports sur chacun desquels au moins deux électrodes sont agencées.

Dans un autre mode de réalisation avantageux, chaque support comprend un tronçon principal connecté par une de ses extrémités au module électronique et deux bras s'étendant de part et d'autre de l'extrémité libre dudit tronçon principal, les électrodes étant agencées sur lesdits bras.

Dans un autre mode de réalisation avantageux, les moyens de commande tactile comprennent un support sur lequel une pluralité électrodes sont agencées, ledit support comprenant un tronçon périphérique connecté par un tronçon secondaire au module électronique, les électrodes étant agencées sur ledit tronçon périphérique.

Dans un autre mode de réalisation avantageux, ledit tronçon périphérique du support présente une forme identique à celle de la boite.

Dans un autre mode de réalisation avantageux, les moyens de commande tactiles sont agencés au niveau de la lunette.

Dans un autre mode de réalisation avantageux, la lunette est une lunette fixe.

Dans un autre mode de réalisation avantageux, la lunette est une lunette tournante.

Dans un autre mode de réalisation avantageux, la carrure et la lunette ne sont qu'une seule pièce pour former une carrure-lunette.

### BREVE DESCRIPTION DES FIGURES

Les buts, avantages et caractéristiques de l'objet ou appareil électronique portable selon la présente invention apparaîtront plus clairement dans la description détaillée suivante d'au moins une forme de réalisation de l'invention donnée uniquement à titre d'exemple non limitatif et illustrée par les dessins annexés sur lesquels :
- La figure 1 représente schématiquement une vue en coupe d'un objet électronique portable selon l'invention;
- La figure 2 représente schématiquement une vue en coupe d'une alternative à lunette tournante d'un objet électronique portable selon l'invention;
- La figure 3 représente schématiquement une vue en coupe d'une alternative à lunette-carrure d'un objet électronique portable selon l'invention;
- Les figures 4 à 6 représente schématiquement des variantes des moyens tactiles selon l'invention;

### DESCRIPTION DETAILLEE

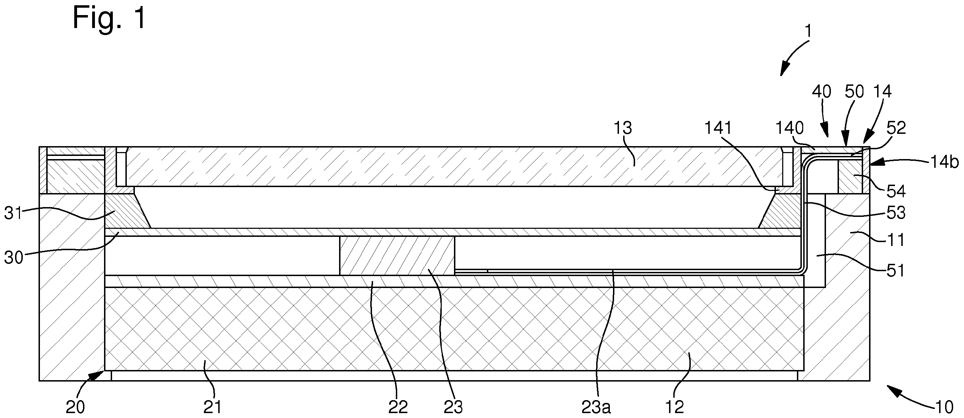

Sur la figure 1, un appareil électronique portable 1 ou objet électronique portable selon l'invention est représenté. Cet objet portable électronique peut être un téléphone portable ou un appareil GPS mobile ou un ordinateur portable ou une tablette tactile, un appareil cardiofréquence-metre pour le sport ou un baladeur de musique ou une pièce d'horlogerie.

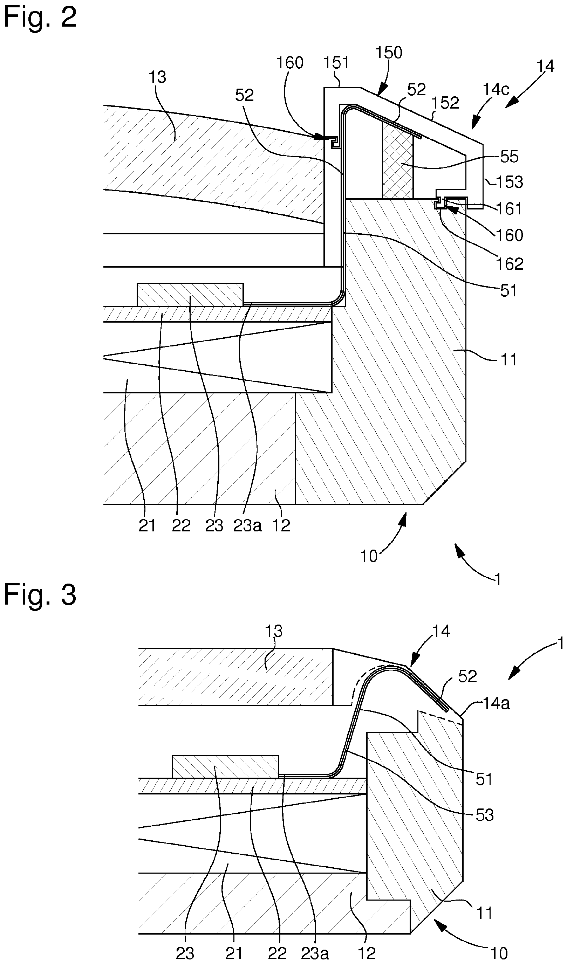

Cet appareil électronique comprend un boîtier 10 appelé aussi boite, constitué d'une carrure 11 fermée par un fond 12 (non représenté sur la figure 1 mais visible à la figure 2) et par une glace 13. Dans ce boîtier 10, un module électronique 20 est agencé. Ce module électronique 20 est configuré pour fournir au moins une information devant être affichée à des moyens d'affichage 30. Ce module électronique 20 est par exemple un mouvement horloger 11 électronique.

Ce module 20 comporte lui-même une platine 21 dont un compartiment ou logement est agencé pour la réception d'un accumulateur d'énergie électrique, notamment une pile.

Ce module 20 comporte également au moins un circuit imprimé 22 ou PCB fixé sur ladite platine. Sur ce circuit imprimé 22, au moins un microcontrôleur 23 est placé et configuré pour fournir au moins une information. Le microcontrôleur 23 peut aussi être un circuit intégré spécifique (ASIC) aux fonctions équivalentes. Ces informations sont envoyées aux moyens d'affichage 30 pouvant être analogiques comme des aiguilles ou digitales comme un écran LCD. Ces moyens d'affichage sont situés entre la glace 13 et le module électronique 20, un espaceur ou rehaut 31 étant agencé entre la glace 13 et les moyens d'affichage 30.

Ce module 20 peut comprendre en outre différents capteurs comme par exemple un capteur de pression pour fournir une information sur l'altitude ou la profondeur ou sur la météo. Un capteur de température ou un capteur pour une fonction boussole peuvent être également agencés. De plus, il est envisageable que plusieurs modules électroniques 20 soient agencés dans la boîte 10, chacun d'eux fournissant au moins une information pour les moyens d'affichage 30.

Dans le cas où l'appareil électronique portable est une pièce d'horlogerie, le module 20 ou un des modules 20 sera un mouvement horloger électronique.

La pièce d'horlogerie 1 comprend en outre des moyens de commande 40 utilisés pour que l'utilisateur puisse interagir avec ledit module 20. Cela permet à l'utilisateur de pouvoir sélectionner les différentes fonctions et de les activer. Les moyens de commande 40 comprennent au moins des moyens de commande tactiles 50. Les moyens de commande peuvent également comprendre des poussoirs ou boutons agencés sur la carrure 11.

Avantageusement selon l'invention, ces moyens de commande tactiles 50 comprennent un support flexible 51 fixé au module électronique 20 et sur lequel au moins une électrode 52 est agencée, ladite électrode 52 étant structurée sur ledit support flexible 51. Ce support flexible 51 est avantageusement un circuit imprimé flexible c'est-à-dire un substrat plastique haute performance, tel que le polyimide (Kapton) ou le polyester. L'électrode 52 déposée se présente sous la forme d'une couche de matériaux conducteurs formant un point de connexion. Par exemple, le circuit imprimé flexible 51 faisant office de support peut être sérigraphié par de l'argent sur du polyester ou le circuit imprimé flexible 51 peut être sérigraphié par du cuivre sur du Kapton. L'électrode 52 possède une forme circulaire ou parallélépipédique voir triangulaire.

Pour relier électriquement l'électrode 52 au microcontrôleur 23, les moyens de commande tactiles 50 comprennent en outre au moins une piste de connexion 53 agencée sur ledit support flexible 51. Cette piste de connexion 53 coopère avec au moins une piste électrique 23a du circuit imprimé 22 connectée audit microcontrôleur. Il est possible d'utiliser des points de connexion sur le circuit imprimé 22 et sur le support 51 pour assurer la continuité électrique. Une colle peut être utilisée pour fixer le support 51 au circuit imprimé 22.

Un avantage de l'utilisation de ces circuits imprimés flexibles 51 est qu'ils permettent un assemblage pouvant être effectué avec les composants utilisés pour des circuits imprimés classiques, tout en autorisant le circuit à respecter une forme particulière, ou en se pliant en cours d'utilisation.

Un autre avantage de l'utilisation d'un support flexible 51 est que le coût d'un tel circuit imprimé flexible est inférieur à celui du dépôt d'une couche ITO sur un substrat tel que la glace de montre.

Enfin, un autre avantage est la simplicité du circuit imprimé flexible 51. En effet, non seulement l'utilisation d'un circuit imprimé flexible 51 n'impose aucune restriction au niveau des composants utilisables, mais la présente invention permet d'avoir une seule pièce pour servir de support à l'électrode 52 et pour connecter cette électrode 52 au circuit de contrôle.

Pour avoir une utilisation proche de celle des montres à glace tactile existantes, il est nécessaire d'avoir une pluralité d'électrode 52. Dans une disposition avantageuse, les moyens de commande tactiles 50 comprennent douze électrodes 52 disposées chacune sur un support 51, douze supports 51 sont donc nécessaires. Ces électrodes 52 sont situées au niveau de la carrure pour que l'utilisateur puisse les manipuler. Bien entendu, il est possible de choisir le nombre d'électrodes 52 et, par exemple, il est possible de n'avoir qu'une électrode 52 ou d'en avoir que 6 ou 7.

Le boîtier 10 comprend à cet effet une lunette 14 pour l'agencement des électrodes 52. Cette lunette 14 est située au niveau de la carrure 11 et enserre la glace 13. Il peut s'agir d'une lunette tournante 14c ou d'une lunette fixe 14b. La lunette 14 peut également être agencée pour que la carrure 11 et la lunette 14 ne forment qu'une seule pièce c'est-à-dire une carrure-lunette 14a. La carrure 11 et la lunette 14 présentent une paroi extérieure qui est la face visible par l'utilisateur et une paroi intérieure. Pour que les électrodes 52 des moyens de commande tactiles 50 soient efficaces, cette lunette 14 est réalisée dans un matériau non conducteur afin que l'effet capacitif puisse avoir lieu. Il est possible que toute la lunette ne soit pas réalisée dans un matériau non conducteur mais que seulement la zone sur lequel l'utilisateur agit soit non conductrice. La sensibilité du système est réduite mais il fonctionne toujours si la taille des électrodes 52 est adaptée c'est-à-dire suffisamment grande.

Préférentiellement, les supports 51 et les électrodes 52 sont agencés sur le tour d'heure de sorte à être manipulables aisément. Ces électrodes 52 sont alors agencés au niveau de la lunette 14 c'est-à-dire au niveau de la carrure-lunette 14a, de la lunette fixe 14b ou de la lunette tournante 14c.

Dans une alternative où les électrodes 52 sont agencées au niveau de la carrure-lunette 14a, les circuits imprimés flexibles 51 sont courbés pour que l'électrode 52 soit en contact avec la paroi intérieure de la carrure-lunette 14a comme visible à la figure 3. Il est envisageable que cette paroi intérieure soit creusée de sorte que les circuits imprimés flexibles 51 puissent s'y caler. Il est également possible de coller ledit circuit imprimé flexible 51 sur cette paroi intérieure.

Dans une autre alternative avec une lunette fixe 14b visible à la figure 1, celle si se présente sous la forme d'une pièce annulaire 140. Dans l'exemple de la figure 1, la pièce annulaire 140 de lunette fixe 14b présente une section en U, la base du U servant de face visible par l'utilisateur. Le bras de cette pièce annulaire qui est situé en regard de la glace est muni d'une excroissance 141 s'étendant depuis l'extrémité libre du bras de façon perpendiculaire audit bras. Cette excroissance 141 est utilisée lors du montage de la glace 13 et de la lunette fixe 14b, la lunette 14b étant montée préalablement à la glace 13 de sorte à prendre appui en partie sur le rehaut 31. Lors du montage de la glace 13, celle-ci prend appui sur l'excroissance 141 de la pièce annulaire 140 de la lunette fixe 14b. La lunette fixe 14b est alors coincée entre la glace 13 et la carrure 11. Cet agencement permet d'avoir une lunette fixe 14b présentant un espace intérieur creux.

Lorsque les électrodes 52 sont agencées au niveau de la lunette fixe 14b, celles-ci le sont dans la partie creuse de la lunette 14b. Pour cela, la carrure 11 est creusée pour qu'un passage soit présent entre le module électronique 20 et l'espace intérieur creux de la lunette comme visible à la figure 1. Pour maintenir le circuit imprimé flexible 51 dans l'espace intérieur creux de la lunette, la solution employée sur la figure 1 consiste à se munir d'une cale 54. Cette cale 54 se place dans l'espace intérieur creux de la lunette. Cette cale 54 est agencée pour se placer entre le circuit imprimé flexible 51 et la carrure 11. De cette façon, la cale 54 agit sur le circuit imprimé flexible 51 afin que l'électrode 52 soit en contact avec la paroi intérieure de la lunette 14b.

Dans une autre alternative avec une lunette tournante 14c, celle si se présente également sous la forme d'une pièce annulaire 150. Dans l'exemple de la figure 2, la pièce annulaire 150 de lunette fixe 14b présente une section en trois parties. Cette section est configurée de sorte que la lunette tournante 14c soit munie de flancs présentant une première portion 151 s'étendant perpendiculairement à la glace 13, une seconde portion 152 s'étendant parallèlement à la glace 13 et une troisième portion 153 inclinée reliant la première portion 151 et la seconde portion 152. A l'extrémité libre de la première portion 151 et de la troisième portion 153, des moyens d'attache 160 sont prévus. Des moyens d'attache 160 sont des parties maies comme des crochets 161 s'insérant dans des gorges 162 de la carrure 11 servant de parties femelles. Cette carrure 11 présente alors un épaulement constitué de deux parois perpendiculaires sur lesquelles les parties femelles sont agencées. La pièce annulaire 150 de la lunette tournante 14c et l'épaulement de la carrure 11 permettent de créer un espace intérieur.

Lorsque les électrodes 52 sont agencées au niveau de la lunette tournante 14c, celles-ci le sont dans la partie creuse de la lunette 14c. Pour cela, la carrure 11 est creusée pour qu'un passage soit présent entre le module électronique 20 et l'espace intérieur creux de la lunette tournante 14c. Comme visible à la figure 2. Pour maintenir le circuit imprimé flexible 51 dans l'espace intérieur creux de la lunette tournante 14c, la solution employée sur la figure 2 consiste à se munir d'une cale 55. Cette cale 55 se place dans l'espace intérieur creux de la lunette tournante 14c. Cette cale 55 est agencée pour se placer entre le circuit imprimé flexible 51 et la carrure 11. De cette façon, la cale 55 soutient le circuit imprimé flexible 51 afin que l'électrode 52 proche de la paroi intérieure de la lunette tournante 14c sans toutefois entrer en contact avec la lunette tournante 14c pour permettre la rotation de la lunette 14c. On pourra également imaginer une armature située dans l'espace intérieur formé par la pièce annulaire 150 de la lunette tournante 14c et l'épaulement de la carrure. Cette armature permet de soutenir le circuit imprimé flexible 51.

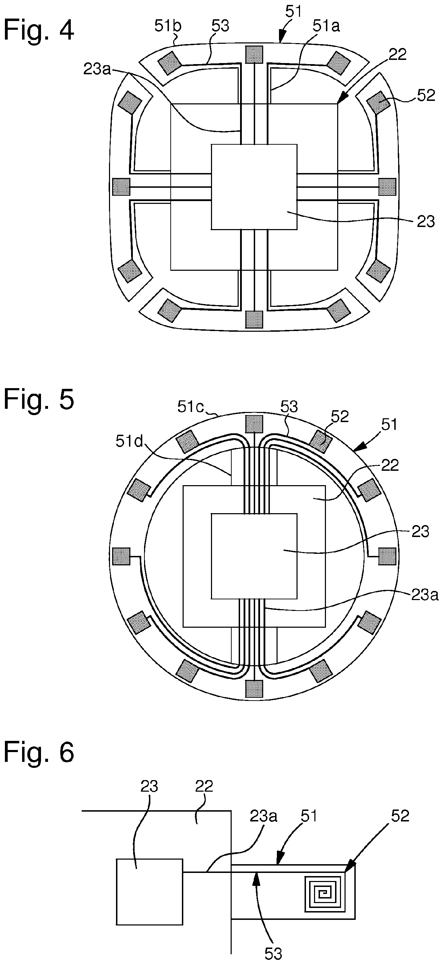

Dans une première variante visible à la figure 4, il est possible d'avoir plus d'une électrode 52 par support c'est-à-dire par circuit imprimé flexible 51. Pour cela, le circuit imprimé flexible 51 présente une forme adaptée. Cette forme adaptée se présente sous la forme d'un T c'est-à-dire que le circuit imprimé flexible 51 comprendre un tronçon principal 51a. Ce tronçon principal 51a est connecté par une de ses extrémités au module électronique alors qu'à son extrémité libre, deux bras 51b s'étendent de part et d'autre. Cette configuration permet d'avoir les différentes électrodes 52 qui sont situées sur l'extrémité du circuit imprimé flexible 51 et au niveau des bras 51b. Les pistes conductrices 53 convergent alors vers le tronçon principal 51a pour ensuite être connectées électriquement au microcontrôleur 23. Préférentiellement, les bras 51b présentent une courbure de sorte à avoir une forme qui suit celle de la lunette 14. Cette courbure des bras 51b permet une meilleure intégration dudit circuit imprimé flexible 51.

Ainsi, pour un objet électronique ayant douze touches tactiles, il est envisageable d'avoir quatre circuits imprimés flexibles 51 selon la présente variante comme visible à la figure 4. Chaque circuit imprimé flexible 51 supporte trois électrodes 52 et voit ses bras 51b formés un arc de cercle. La somme des arcs de cercle des quatre circuits imprimés flexibles 51 est un cercle similaire à celui formé par la lunette 14.

Dans une seconde variante visible à la figure 5, les moyens de commande tactile 50 comprennent un seul circuit imprimé flexible 51 agencé pour supporter toute les électrodes 52. Pour cela, le circuit imprimé flexible 51 comprend un tronçon périphérique 51c sur lequel les différentes électrodes 52 sont réalisées. Ce tronçon périphérique 51c présente une forme identique à cette de la boite 10 c'est-à-dire que sa forme peut être annulaire ou carré ou en forme de tonneau. Le tronçon périphérique 51c est relié au microcontrôleur 23 du module électronique 20 par au moins un tronçon secondaire 51d s'étendant radialement par rapport au tronçon annulaire 51c. Les pistes conductrices 53 convergent vers ce tronçon secondaire 51d pour être connectées électriquement les électrodes 52 au microcontrôleur 23.

Dans une version préférentielle de cette seconde variante visible à la figure 5, le circuit imprimé flexible 51 comprend deux tronçons secondaires 51d. Ces tronçons secondaires 51d sont diamétralement opposés. Cette version préférentielle a l'avantage de permettre de simplifier la connexion électrique entre les électrodes 52 et le microcontrôleur 23. Les pistes conductrices 53 sont alors divisées en deux groupes, chacun convergeant vers un tronçon secondaire 51d. On comprendra que les pistes 53 qui sont angulairement distantes d'un tronçon secondaire 51d d'un angle inférieur ou égal à 90° convergent vers celui-ci.

Un avantage de cette seconde variante est qu'elle permet une simplification du processus de fabrication car il n'y a qu'un seul circuit imprimé à réaliser et à fixer au module électronique 20.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

Ainsi, il est envisageable que les électrodes 52 se présentent sous la forme de la piste conductrice 53 qui, à son extrémité libre, est enroulée sur elle-même, la piste n'entrant pas en contact avec elle-même comme visible à la figure 6.

## Revendications

1. Objet électronique portable (1) muni d'un boîtier (10) comprenant une carrure (11) fermée par un fond et par une glace (13) et une lunette (14) fixée à la carrure, ledit boîtier enfermant au moins un module électronique (20) constitué d'un circuit imprimé (22) sur lequel est fixé au moins un microcontrôleur (23) envoyant des informations à des moyens d'affichage (30), ledit objet comportant en outre des moyens de commande tactiles (50) comprenant au moins un support (51) flexible sur lequel au moins une électrode (52) est structurée, ladite électrode étant électriquement reliée au microcontrôleur par une piste conductrice (53), **caractérisé en ce que** le support (51) est agencé pour être déformé pour s'adapter aux formes de l'objet portable et **en ce que** le support (51) est fixé et directement connecté audit circuit imprimé (22).

2. Objet électronique selon la revendication 1, **caractérisé en ce que** le support (51) est réalisé en un plastique, l'électrode (52) étant une couche de matériaux conducteurs déposée sur ledit support.

3. Objet électronique selon la revendication 1 ou 2, **caractérisé en ce que** les moyens de commande tactiles (50) comprennent une pluralité de supports (51) sur chacun desquels une électrode (52) est agencée.

4. Objet électronique selon la revendication 1 ou 2, **caractérisé en ce que** les moyens de commande tactiles (50) comprennent une pluralité de supports (51) sur chacun desquels au moins deux électrodes (52) sont agencées.

5. Objet électronique selon la revendication 4, **caractérisé en ce que** chaque support (51) comprend un tronçon principal (51a) connecté par une de ses extrémités au module électronique et deux bras (51b) s'étendant de part et d'autre de l'extrémité libre dudit tronçon principal, les électrodes étant agencées sur lesdits bras.

6. Objet électronique selon la revendication 1 ou 2, **caractérisé en ce que** les moyens commande tactiles comprennent un support sur lequel une pluralité électrodes sont agencées, ledit support (51) comprenant un tronçon périphérique (51c) connecté par un tronçon secondaire (51d) au module électronique, les électrodes étant agencées sur ledit tronçon périphérique (51c).

7. Objet électronique selon la revendication 6, **caractérisé en ce que** ledit tronçon périphérique (51c) du support (51) présente une forme identique à celle de la boite.

8. Objet électronique selon l'une des revendications précédentes, **caractérisé en ce que** les moyens de commande tactile (50) sont agencés au niveau de la lunette (14).

9. Objet électronique selon la revendication 8, **caractérisé en ce que** la lunette (14) est une lunette fixe (14b).

10. Objet électronique selon la revendication 8, **caractérisé en ce que** la lunette (14) est une lunette tournante (14c).

11. Objet électronique selon la revendication 8, **caractérisé en ce que** la carrure (11) et la lunette (14) ne sont qu'une seule pièce pour former une carrure-lunette (14a).

## Patentansprüche

1. Tragbarer Elektronischer Gegenstand (1), der mit einem Gehäuse (10) versehen ist, das einen Mittelteil (11), der durch einen Boden und durch ein Uhrenglas (13) verschlossen ist, und eine an dem Mittelteil befestigte Lünette (14) umfasst, wobei das Gehäuse mindestens ein elektronisches Modul (20) umschließt, das durch eine Leiterplatte (22) gebildet ist, auf der mindestens eine Mikrosteuereinheit (23) befestigt ist, die zu Anzeigemitteln (30) Informationen sendet, wobei der Gegenstand ferner Mittel zur Berührungssteuerung (50) umfasst, die mindestens einen biegsamen Träger (51) aufweisen, auf dem mindestens eine Elektrode (52) strukturiert ist, wobei die Elektrode mit der Mikrosteuereinheit durch eine Leiterbahn (53) elektrisch verbunden ist, **dadurch gekennzeichnet, dass** der Träger (51) dafür ausgelegt ist, verformt zu werden, um sich an die Formen des tragbaren Gegenstands anzupassen, und dass der Träger (51) an der Leiterplatte (22) befestigt und mit ihr direkt verbunden ist.

2. Elektronischer Gegenstand nach Anspruch 1, **dadurch gekennzeichnet, dass** der Träger (51) aus Kunststoff hergestellt ist, wobei die Elektrode (52) eine Schicht aus leitenden Materialien ist, die auf den Träger aufgebracht ist.

3. Elektronischer Gegenstand nach Anspruch 1 oder 2, **dadurch gekennzeichnet, dass** die Mittel zur Berührungssteuerung (50) eine Mehrzahl von Trägern (51) umfassen, wovon auf jedem eine Elektrode (52) angeordnet ist.

4. Elektronischer Gegenstand nach Anspruch 1 oder 2, **dadurch gekennzeichnet, dass** die Berührungssteuermittel (50) mehrere Träger (51) umfassen, wovon auf jedem mindestens zwei Elektroden (52) angeordnet sind.

5. Elektronischer Gegenstand nach Anspruch 4, **dadurch gekennzeichnet, dass** jeder Träger (51) ein Hauptteilstück (51a), das mit einem seiner Enden mit dem elektronischen Modul verbunden ist, und zwei Arme (51b), die sich auf beiden Seiten des freien Endes des Hauptteilstücks erstrecken, umfasst, wobei die Elektroden auf den Armen angeordnet sind.

6. Elektronischer Gegenstand nach Anspruch 1 oder 2, **dadurch gekennzeichnet, dass** die Mittel zur Berührungssteuerung einen Träger umfassen, auf dem eine Mehrzahl von Elektroden angeordnet sind, wobei der Träger (51) ein Umfangsteilstück (51c) umfasst, das über ein sekundäres Teilstück (51d) mit dem elektronischen Modul verbunden ist, wobei die Elektroden auf dem Umfangsteilstück (51c) angeordnet sind.

7. Elektronischer Gegenstand nach Anspruch 6, **dadurch gekennzeichnet, dass** das Umfangsteilstück (51c) des Trägers (51) eine Form aufweist, die mit jener des Gehäuses übereinstimmt.

8. Elektronischer Gegenstand nach einem der vorhergehenden Ansprüche, **dadurch gekennzeichnet, dass** die Mittel zur Berührungssteuerung (50) auf Höhe der Lünette (14) angeordnet sind.

9. Elektronischer Gegenstand nach Anspruch 8, **dadurch gekennzeichnet, dass** die Lünette (14) eine feste Lünette (14b) ist.

10. Elektronischer Gegenstand nach Anspruch 8, **dadurch gekennzeichnet, dass** die Lünette (14) eine drehbare Lünette (14c) ist.

11. Elektronischer Gegenstand nach Anspruch 8, **dadurch gekennzeichnet, dass** der Mittelteil (11) und die Lünette (14) nur ein einziges Teil sind, um einen Lünetten-Mittelteil (14a) zu bilden.

## Claims

1. Portable electronic object (1) provided with a case (10) including a middle part (11) closed by a back cover and by a glass (13) and a bezel (14) fixed to the middle part, said case containing at least one electronic module (20) formed of a printed circuit board (22) on which is fixed at least one microcontroller (23) sending information to display means (30), said object further including touch control means (50) including at least one flexible base element (51) on which at least one electrode (52) is structured, said electrode being electrically connected to the microcontroller by a conductive track (53), **characterized in that** the base element (51) is arranged so as to be deformed in order to adapt to the shapes of the portable object and **in that** the base element (51) is fixed and directly connected to said printed circuit board (22).

2. Electronic object according to claim 1, **characterized in that** the base element (51) is made of a plastic, the electrode (52) being a layer of conductive materials deposited on said base element.

3. Electronic object according to claim 1 or 2, **characterized in that** the touch control means (50) include a plurality of base elements (51) on each of which is arranged an electrode (52).

4. Electronic object according to claim 1 or 2, **characterized in that** the touch control means (50) include a plurality of base elements (51) on each of which at least two electrodes (52) are arranged.

5. Electronic object according to claim 4, **characterized in that** each base element (51) includes a main section (51a) connected via one of the ends thereof to the electronic module and two arms (51b) extending on both sides of the free end of said main section, the electrodes being arranged on said arms.

6. Electronic object according to claim 1 or 2, **characterized in that** the touch control means include a base element on which there are arranged a plurality of electrodes, said base element (51) including a peripheral section (51c) connected by a secondary section (51d) to the electronic module, the electrodes being arranged on said peripheral section (51c).

7. Electronic object according to claim 6, **characterized in that** said peripheral section (51c) of the base element (51) has an identical shape to that of the case.

8. Electronic object (1) according to any of the preceding claims, **characterized in that** the touch control means (50) are arranged on the bezel (14).

9. Electronic object according to claim 8, **characterized in that** the bezel (14) is a fixed bezel (14b).

10. Electronic object according to claim 8, **characterized in that** the bezel (14) is a rotating bezel (14c).

11. Electronic object according to claim 8, **characterized in that** the middle part (11) and the bezel (14) are in a single piece to form a middle part/bezel (14a).
